Europäisches Patentamt

European Patent Office

Office européen des brevets

(19)

(11) Veröffentlichungsnummer : **0 075 236**
**B1**

(12)　　　　　　　　　# EUROPÄISCHE PATENTSCHRIFT

(45) Veröffentlichungstag der Patentschrift :
**09.01.85**

(51) Int. Cl.⁴ : **G 03 C    1/68**

(21) Anmeldenummer : **82108422.5**

(22) Anmeldetag : **13.09.82**

(54) **Fotopolymerisierbare Gemische und Elemente daraus.**

(30) Priorität : **19.09.81 DE 3137416**

(43) Veröffentlichungstag der Anmeldung :
**30.03.83 Patentblatt 83/13**

(45) Bekanntmachung des Hinweises auf die Patenterteilung : **09.01.85 Patentblatt 85/02**

(84) Benannte Vertragsstaaten :
**BE CH DE FR GB IT LI NL SE**

(56) Entgegenhaltungen :
**EP-A- 0 027 612**
**FR-A- 2 322 886**
**FR-A- 2 387 264**

(73) Patentinhaber : **BASF Aktiengesellschaft**
**Carl-Bosch-Strasse 38**
**D-6700 Ludwigshafen (DE)**

(72) Erfinder : **Heinz, Gerhard, Dr.**
**Im Vogelsang 2**
**D-6719 Weisenheim (DE)**
Erfinder : **Richter, Peter, Dr.**
**Bensheimer Ring 24**
**D-6710 Frankenthal (DE)**
Erfinder : **Mueller, Wolfgang F., Dr.**
**Hahnenweg 20**
**D-6730 Neustadt (DE)**

EP 0 075 236 B1

## Beschreibung

Die Erfindung betrifft fotopolymerisierbare Gemische zur Herstellung von lichthärtenden Klebstoffen, weichelastischen Folienbahnen und Reliefformen, die neben einem Fotoinitiator und mindestens einer ethylenisch ungesättigten, niedermolekularen Verbindung ein elastomeres Blockcopolymerisat enthalten.

Fotopolymerisierbare Gemische für die Herstellung von Formteilen, insbesondere Reliefdruckplatten für den Flexodruck, sind an sich bekannt und z. B. in den britischen Patentschriften 1 366 769 und 1 395 822, den deutschen Offenlegungsschriften 28 15 678, 29 39 989 und 29 42 183 und den US-Patentschriften 3 674 486, 4 045 231, 4 162 919 und 4 179 531 beschrieben. Diese bekannten fotopolymerisierbaren Gemische enthalten als Polymeres für die reliefbildende fotopolymerisierbare Schicht elastomere Blockcopolymerisate, die neben mindestens einem elastomeren Polymerblock, beispielsweise aus Isopren oder Butadien, mindestens einen nicht-elastomeren, thermoplastischen Polymerblock, beispielsweise aus Polystyrol, enthalten. Die aus diesen fotopolymerisierbaren Gemischen hergestellten Reliefdruckplatten neigen jedoch beim Lagern, insbesondere wenn sie auf Druckzylinder aufgespannt sind, zur Ausbildung von Rissen in der Druckoberfläche. Durch diese Rißbildung wird die Qualität der Drucke stark beeinträchtigt und eine einmal hergestellte Druckplatte innerhalb von wenigen Tagen für die Wiederverwendung ungeeignet.

Aufgabe der vorliegenden Erfindung war es, fotopolymerisierbare Gemische aufzuzeigen, die für die Herstellung von Reliefformen, insbesondere für die Herstellung von Druckformen für den Flexodruck geeignet sind, sich in einfacher und wirtschaftlicher Weise mit gut reproduzierbaren Eigenschaften herstellen und nach den bekannten Methoden verarbeiten lassen und zu Reliefdruckformen führen, die nicht nur vorlagengetreue Drucke liefern und eine gute Beständigkeit gegenüber den üblichen Druckfarbenlösungsmittel aufweisen, sondern gleichzeitig eine äußerst geringe Neigung zur Rißbildung besitzen, so daß sie selbst bei Lagerung über längere Zeiträume eine hohe Wiederverwendbarkeit besitzen.

Es wurde nun überraschenderweise gefunden, daß diese Aufgabe gelöst wird, wenn in den fotopolymerisierbaren Gemischen als polymeres Bindemittel ein elastomeres Blockcopolymerisat mit mindestens drei Polymerblöcken enthalten ist, welches keinen thermoplastischen Polymerblock enthält, sondern nur aus elastomeren Polymerblöcken mit unterschiedlichen Glasübergangstemperaturen aufgebaut ist.

Gegenstand der Erfindung sind dementsprechend fotopolymerisierbare Gemische, enthaltend

(a) 40 bis 99 Gew.%, bezogen auf (a) und (b), mindestens eines in einem Entwicklerlösungsmittel löslichen elastomeren Blockcopolymerisats mit mindestens drei chemisch miteinander verknüpften Polymerblöcken,

(b) 1 bis 60 Gew.%, bezogen auf (a) und (b), mindestens einer mit dem elastomeren Blockcopolymerisat (a) verträglichen, fotopolymerisierbaren, ethylenisch ungesättigten niedermolekularen Verbindung,

(c) 0,1 bis 10 Gew.%, bezogen auf das gesamte fotopolymerisierbare Gemisch, mindestens eines Fotopolymerisationsinitiators sowie

(d) 0 bis 40 Gew.%, bezogen auf das gesamte fotopolymerisierbare Gemisch, an weiteren Zusatzstoffen,

welche dadurch gekennzeichnet sind, daß das Blockcopolymerisat (a) nur aus elastomeren Polymerblöcken aufgebaut ist, wobei das Blockcopolymerisat wenigstens zwei elastomere Polymerblöcke mit einer Glasübergangstemperatur zwischen − 20 °C und + 15 °C sowie mindestens einen zwischen diesen beiden Blöcken liegenden elastomeren Polymerblock mit einer Glasübergangstemperatur unter − 20 °C enthält.

Gegenstand der Erfindung sind weiterhin zur Herstellung von Reliefdruckformen geeignete, lichtempfindliche Mehrschichtenelemente, die auf einem dimensionsstabilen Träger eine lichtempfindliche Schicht aus dem oben beschriebenen fotopolymerisierbaren Gemisch enthalten. Gegenstand der Erfindung sind darüber hinaus spezielle Ausgestaltungsformen der fotopolymerisierbaren Gemische bzw. der Mehrschichtenelemente gemäß der nachfolgenden detaillierten Beschreibung.

Nachdem gemäß dem Stand der Technik in fotopolymerisierbaren Gemischen immer nur Blockcopolymerisate eingesetzt worden sind, die mindestens einen thermoplastischen Polymerblock enthalten, war es nicht nur überraschend, daß für die Herstellung von Reliefdruckformen geeignete fotopolymerisierbare Gemische auch dann erhalten werden, wenn diese Gemische als polymeres Bindemittel Blockcopolymerisate enthalten, die nur aus elastomeren Polymerblöcken aufgebaut sind, sondern es war darüber hinaus auch in keiner Weise vorherzusehen, daß mit den erfindungsgemäßen fotopolymerisierbaren Gemischen Reliefdruckformen hergestellt werden können, die neben ausgezeichneten Druck- und anwendungstechnischen Eigenschaften ohne besondere zusätzliche Maßnahmen eine hohe Beständigkeit gegenüber Rißbildung bei der Lagerung aufweisen.

Die fotopolymerisierbaren Gemische der Erfindung enthalten als Bindemittel-Komponente (a) Blockcopolymerisate, die keine thermoplastischen Blöcke enthalten und aus mindestens drei elastomeren Polymerblöcken aufgebaut sind, wobei zwischen zwei elastomeren Polymerblöcken mit einer Glasübergangstemperatur zwischen − 20 °C und + 15 °C mindestens ein, und vorzugsweise nur ein von diesen beiden Polymerblöcken verschiedener elastomerer Polymerblock mit einer Glasübergangstemperatur unter − 20 °C angeordnet ist. Die elastomeren Polymerblöcken mit einer Glasübergangstemperatur zwischen − 20 °C und + 15 °C können dabei sowohl bezüglich ihres chemischen Aufbaus als auch bezüglich ihres Molekulargewichts gleich oder verschieden sein, wobei es sich als vorteilhaft herausgestellt hat, wenn diese elastomeren Polymerblöcke gleich sind. Des weiteren können die erfindungsgemäß einzusetzenden Blockcopolymerisate auch mehrere elastomere Polymerblöcke mit einer Glasübergangstemperatur unter − 20 °C enthalten, sofern mindestens einer der elastomeren Polymerblöcke mit einer Glasübergangstemperatur unterhalb − 20 °C zwischen zwei elastomeren Polymerblöcken mit einer Glasübergangstemperatur zwischen − 20 °C und + 15 °C angeordnet ist. Vorzugsweise kommen solche elastomeren Blockcopolymerisate zur Anwendung, bei denen die elastomeren Polymerblöcke mit einer Glasübergangstemperatur zwischen − 20 °C und + 15 °C endständig sind. Neben Dreiblock-Copolymerisaten gehören hierzu beispielsweise auch Fünfblock- oder Siebenblock-Copolymerisate. Vorzugsweise werden in den erfindungsgemäßen fotopolymerisierbaren Gemischen elastomere Dreiblock-Copolymerisate eingesetzt, bei denen die beiden endständigen elastomeren Polymerblöcke mit Glasübergangstemperaturen zwischen − 20 °C und + 15 °C durch einen mittelständigen elastomeren Polymerblock mit einer Glasübergangstemperatur unter − 20 °C verbunden sind.

Die elastomeren Blockcopolymerisate (a) für die erfindungsgemäßen Gemische haben im allgemeinen Viskositätszahlen, gemessen als 0,5 gew.%ige, toluolische Lösung bei 25 °C, im Bereich von etwa 60 bis 350 ml/g und insbesondere von etwa 100 bis 200 ml/g, was einem mittleren Molekulargewicht $M_v$ von 60 000 bis 300 000, vorzugsweise von etwa 100 000 bis 200 000 entspricht. Die elastomeren Polymerblöcke mit einer Glasübergangstemperatur zwischen − 20 °C und + 15 °C haben üblicherweise ein mittleres Molekulargewicht (Viskositätsmittel) im Bereich von 5 000 bis etwa 100 000 ; das mittlere Molekulargewicht (Viskositätsmittel) der elastomeren Polymerblöcke mit einer Glasübergangstemperatur unter − 20 °C liegt im allgemeinen im Bereich von etwa 20 000 bis 200 000. Dementsprechend kann der Anteil der einzelnen Polymerblöcke am Blockcopolymerisat in weiten Grenzen schwanken, z. B. können der oder die elastomeren Polymerblöcke mit einer Glasübergangstemperatur unter − 20 °C 10 bis 90 Gew.% des gesamten Blockcopolymerisats ausmachen. Sehr geeignete Blockcopolymerisate enthalten 40 bis 90 Gew.% an elastomeren Polymerblöcken mit einer Glasübergangstemperatur unterhalb − 20 °C und 60 bis 10 Gew.% an elastomeren Polymerblöcken mit einer Glasübergangstemperatur im Bereich von − 20 °C bis + 15 °C.

Die erfindungsgemäß zu verwendenden elastomeren Blockcopolymerisate sind insbesondere aus aliphatischen konjugierten Diolefinen und vinylaromatischen Kohlenwasserstoffen aufgebaut. Als Diolefine sind dabei die aliphatischen konjugierten Dienkohlenwasserstoffe mit 4 bis 5 C-Atomen, insbesondere Butadien und Isopren, bevorzugt. Unter den vinylaromatischen Kohlenwasserstoffen sind insbesondere Styrol und Styrol-Derivate, wie z. B. kern- und seitenkettensubstituierte Styrole, besonders geeignet. Styrol und Styrol-Derivate werden im folgenden aus Gründen der Einfachheit auch zusammenfassend als Styrol-Monomere bezeichnet. Als Beispiele für Styrol-Monomere seien genannt α-Methylstyrol, Vinyltoluole, tert.-Butylstyrol und insbesondere Styrol selbst.

Der elastomere Polymerblock mit einer Glasübergangstemperatur unter − 20 °C kann beispielsweise ein reiner Polybutadien-Block oder Polyisopren-Block sein ; bei diesem Polymerblock kann es sich jedoch gleichermaßen um ein Mischpolymerisat aus Butadien und Isopren oder aus Butadien und/oder Isopren und Styrol-Monomeren mit statistischer Verteilung der eingebauten Monomeren handeln. Sofern der elastomere Polymerblock mit einer Glasübergangstemperatur unter − 20 °C Styrol-Monomere eingebaut enthält, ist der Anteil dieser Monomere so bemessen, daß die Glasübergangstemperatur dieses Polymerblockes − 20 °C nicht übersteigt. Vorzugsweise handelt es sich bei dem oder den elastomeren Polymerblöcken mit einer Glasübergangstemperatur unter − 20 °C um reine Polybutadien-Blöcke und insbesondere um reine Polyisopren-Blöcke.

Die elastomeren Polymerblöcke mit einer Glasübergangstemperatur zwischen − 20 °C und + 15 °C der erfindungsgemäß einzusetzenden blockcopolymerisate sind aufgrund ihrer unterschiedlichen Glasübergangstemperatur auch hinsichtlich ihres chemischen Aufbaus von dem elastomeren Polymerblock mit einer Glasübergangstemperatur unter − 20 °C unterschieden. Beispielsweise kann es sich bei den elastomeren Polymerblöcken mit einer Glasübergangstemperatur zwischen − 20 °C und + 15 °C um einen Homopolymerisat-Block aus Butadien, der mehr als 75 Gew.% des Butadiens in 1,2-Konfiguration einpolymerisiert enthält, oder um einen Homopolymerisat-Block aus Isopren, der mehr als 40 Gew.% des Isoprens in 3,4-Konfiguration einpolymerisiert enthält, handeln. Insbesondere stellen jedoch die elastomeren Polymerblöcke mit einer Glasübergangstemperatur zwischen − 20 °C und + 15 °C Copolymerisat-Blöcke aus aliphatischen konjugierten Dienkohlenwasserstoffen mit 4 bis 5 C-Atomen, wie Butadien und/oder Isopren, und den Styrol-Monomeren dar, wobei der Copolymerisat-Block die Comonomeren in statistischer Verteilung eingebaut enthält. Der Anteil der einpolymerisierten Dienkohlenwasserstoffe in einem solchen statistischen Copolymerisat-Block beträgt zweckmäßigerweise 65 bis 30 Gew.%, insbesondere 50 bis 30 Gew.%, der des einpolymerisierten Styrol-Monomeren zweckmäßigerweise 35 bis 70 Gew.%, insbesondere 50 bis 70 Gew.%, jeweils bezogen auf das Gewicht des statistischen Copolymerisat-Blocks, wobei das Verhältnis der jeweiligen Comonomeren insbesondere durch die geforderte Glasübergangstemperatur des Polymerblocks begrenzt wird.

0 075 236

Als typisches Beispiel für die erfindungsgemäß einzusetzenden elastomeren Blockcopolymerisate seien Dreiblock-Copolymerisate genannt, deren beide endständige Polymerblöcke aus statistischen Copolymerisatblöcken von Styrol und Butadien und/oder Isopren gebildet werden, und deren mittelständiger Polymerblock ein Butadien- oder Isopren-Homopolymerisatblock ist.

Die in den fotopolymerisierbaren Gemischen erfindungsgemäß einzusetzenden elastomeren Blockcopolymerisate können nach den für die Herstellung von Blockcopolymerisaten an sich bekannten und üblichen Verfahrensweisen und Techniken erhalten werden. Die Blockcopolymerisate aus den aliphatischen Dienkohlenwasserstoffen und den Styrol-Monomeren lassen sich beispielsweise vorteilhaft durch sequentielle, anionische Polymerisation herstellen, wobei man in den Fällen, in denen statistische Copolymerisat-Blöcke aus den Comonomeren erhalten werden sollen, vorteilhafterweise nach der sogenannten Zulauftechnik arbeitet. Im übrigen sei bezüglich der Herstellverfahren für die Blockcopolymerisate auf die einschlägige Fachliteratur verwiesen.

Für bestimmte Anwendungszwecke und verbesserte Oxidations- und Alterungsbeständigkeit können die erfindungsgemäß einzusetzenden elastomeren Blockcopolymerisate auf Basis von Dienkohlenwasserstoffen auch teilweise oder vollständig hydiert werden. Bei den hydrierten Blockcopolymerisaten kann es sich auch um selektiv hydrierte Produkte handeln, bei denen nur die olefinischen Doppelbindungen, nicht aber die aromatischen Doppelbindungen des Blockcopolymerisats hydriert worden sind.

Je nach speziellem Anwendungszweck ist es natürliche möglich, in den fotopolymerisierbaren Gemischen als polymeres Bindemittel (a) auch Gemische von elastomeren Blockcopolymerisaten der genannten Art zu verwenden bzw. sie mit untergeordneten Mengen an anderen verträglichen Polymeren, insbesondere Elastomeren, abzumischen.

Durch die Art der verwendeten elastomeren Blockcopolymerisate, beispielsweise in Abhängigkeit der Molekulargewichte und chemischen Zusammensetzung der einzelnen Polymerblöcke, können die mechanischen und anwendungstechnischen Eigenschaften der erfindungsgemäßen fotopolymerisierbaren Gemische in weitem Umfang und je nach dem speziellen Anwendungszwecke gesteuert werden. Zur Handhabung unvernetzter, unbelichteter Schichten aus den erfindungsgemäßen fotopolymerisierbaren Gemischen ist es so z. B. sinnvoll, fotopolymerisierbare Gemische zusammenzustellen, deren kaltes Fließen bzw. deren Neigung zur plastischen Deformation möglichst gering ist und die im allgemeinen bei Raumtemperatur fest und nicht klebrig sind.

Die fotopolymerisierbaren Gemische der Erfindung enthalten als Komponente (b) mindestens eine fotopolymerisierbare ethylenisch ungesättigte niedermolekulare Verbindung, die mit dem elastomeren Blockcopolymerisat (a) verträglich ist und einen Siedepunkt bei Atmosphärendruck im allgemeinen über 100 °C besitzen soll. Als fotopolymerisierbare ethylenisch ungesättigte niedermolekulare Verbindungen, die im allgemeinen ein Molekulargewicht unter 3 000, vorzugsweise bis zu 2 000 haben, kommen die für fotopolymerisierbare Gemische an sich bekannten fotopolymerisierbaren Monomere und/oder Oligomere in Betracht, wie sie beispielsweise in den US-A-2 760 863 und 3 060 023 beschrieben sind. Unter den fotopolymerisierbaren, ethylenisch ungesättigten niedermolekularen Verbindungen sind die Ester der Acrylsäure und/oder Methacrylsäure mit ein- oder mehrwertigen Alkoholen von besonderer Bedeutung. Hierzu gehören unter anderem Butylacrylat, Butylmethacrylat, 2-Ethylhexylacrylat, Lauryl(meth)acrylat, Ethylenglykol-di(meth)acrylat, Butandiol-1,4-di(meth)acrylat, Neopentylglykoldi(meth)acrylat, 3-Methylpentandioldiacrylat, 2-Hydroxypropyl(meth)acrylat, 2-Hydroxyethyl(meth)crylat, Hexandiol-1,6-di(meth)acrylat, 1,1,1-Trimethylolpropantriacrylat und -trimethacrylat, Di-, Tri- und Tetraethylenglykoldiacrylat, Tripropylenglykoldiacrylat, Pentaerythrittetraacrylat. Geeignet sind auch Vinylester aliphatischer Monocarbonsäuren, wie Vinyloleat, und Vinylether von Alkoholen, wie Octadecylvinylether oder Butandiol-1,4-divinylether. In gleicher Weise kommen als Komponente (b) der erfindungsgemäßen fotopolymerisierbaren Gemische auch die Diester von Fumar- oder Maleinsäure in Betracht, wie sie beispielsweise in der DE-A 28 15 678 beschrieben sind, oder auch Umsetzungsprodukte aus OHterminierten, oligomeren Polybutadienen mit Maleinsäureanhydrid oder (Meth)acrylsäure zu oligomeren Polybutadienen mit aktivierten, fotopolymerisierbaren olefinischen Doppelbindungen.

Sehr geeignete erfindungsgemäße fotopolymerisierbare Gemische enthalten 60 bis 95 Gew.% des elastomeren Blockcopolymerisats (a) und 40 bis 5 Gew.% der fotopolymerisierbaren ethylenisch ungesättigten niedermolekularen Verbindung (b), wobei die Prozentangaben jeweils auf die Summe der Komponenten (a) und (b) bezogen sind.

Das fotopolymerisierbare Gemisch enthält darüber hinaus eine wirksame Menge, im allgemeinen 0,01 bis 10 Gew.% und insbesondere 0,05 bis 5 Gew.%, bezogen auf das gesamte fotopolymerisierbare Gemisch, mindestens eines Fotopolymerisationsinitiators, wie z. B. Benzoin, Benzoinderivate, wie dessen Methyl-, Isopropyl-, n-Butyl- oder iso-Butylether ; symmetrisch oder unsymmetrisch substituierte Benzylketale, wie Benzildimethylketal, Benzilmethylketol ; oder Acylphosphinoxide des Typs, wie sie z. B. in der DE-A 29 09 992 beschrieben sind ; oder substituierte und unsubstituierte Chinone, wie z. B. Ethylanthrachinon, Benzanthrachinon, Benzophenon und 4,4'-Bis(dimethylamino)benzophenon. Die Fotopolymerisationsinitiatoren können allein oder im Gemisch miteinander oder in Verbindung mit anderen Coinitiatoren verwendet werden, z. B. Ethylanthrachinon mit 4,4'-Bis(dimethylamino)benzophenon, Benzoinmethylether mit Triphenylphosphin und Diacylphosphinoxide mit tertiären Aminen.

Die fotopolymerisierbaren Gemische können ferner noch weitere Zusatz- und Hilfsstoffe enthalten,

4

wie sie zur Verbesserung der Handhabbarkeit und Verarbeitbarkeit von Gemischen der in Rede stehenden Art üblich und bekannt sind. Hierzu gehören insbesondere thermische Polymerisationsinhibitoren, wie beispielsweise p-Methoxyphenol, Hydrochinon, 2,6-Di-tert.-butyl-p-kresol, β-Naphthol, m-Dinitrobenzol, N-Nitrosoamine, wie N-Nitrosodiphenylamin, oder die Salze, beispielsweise die Kalium- oder Aluminiumsalze des Nitrosocyclohexylhydroxylamins. Voraussetzung für die Auswahl derartiger Inhibitoren ist das Fehlen einer nennswerten Eigenabsorption in dem aktinischen Bereich, in dem der gleichzeitig verwendete Fotoinitiator absorbiert. Die thermischen Polymerisationsinhibitoren werden im allgemeinen in Mengen von 0,001 bis 2 Gew.%, vorzugsweise in Mengen von 0,005 bis 0,5 Gew.%, bezogen auf das gesamte fotopolymerisierbare Gemisch, eingesetzt. Insbesondere bei den erfindungsgemäßen Gemischen, die elastomere Blockcopolymerisate mit Polybutadien-Blöcken enthalten, ist die Verwendung von Inhibitoren empfehlenswert, die als Antioxidans gegen einen oxidativen Kautschukabbau wirken.

Zur Steuerung der Belichtungseigenschaften der erfindungsgemäßen fotopolymerisierbaren Gemische können in den Gemischen ferner Farbstoffe oder fotochrome Zusätze enthalten sein. Der Zusatz von Farbstoffen oder Pigmenten kann auch der Identifizierung oder ästhetischen Zwecken dienen, vorausgesetzt, daß die Farbstoffe die aktinische Strahlung nicht stark absorbieren und die Fotopolymerisationsreaktion nicht stören.

Die fotopolymerisierbaren Gemische können darüber hinaus vorteilhafterweise noch weitere Zusätze, wie z. B. verträgliche Weichmacher, Wachse, Füllstoffe oder Vernetzungshilfsmittel enthalten, mit deren Hilfe bestimmte, vom jeweiligen Anwendungsgebiet abhängige, spezielle Eigenschaften eingestellt und verbessert werden können. Beispielsweise empfiehlt sich ein Zusatz von Weichmachern besonders dann, wenn die fotopolymerisierbaren Gemische zur Herstellung von weichelastischen Schichten mit gutem Rückstellverhalten eingesetzt werden sollen, wie sie beispielsweise bei fotopolymerisierbaren Aufzeichnungsmaterialien zur Herstellung von weichelastischen Reliefdruckplatten benötigt werden. Beispiele für Weichmacher sind Phthalsäureester, Paraffinöle, naphthenische und/oder aromatische Öle, niedermolekulare flüssige Polyisopren- oder Polybutadien-Verbindungen. Durch Zusatz von anderen Stoffen, wie z. B. bestimmten Polymeren oder Füllstoffen, beispielsweise von Oligomerstyrol, niedermolekularen Styrolcopolymerisaten, statistischen Styrol/Butadien-Copolymerisaten mit hohen Styrolgehalten oder von α-Methylstyrol-Copolymerisaten, kann die Härte von belichteten Schichten, die aus den erfindungsgemäßen fotopolymerisierbaren Gemischen hergestellt worden sind, erhöht werden. Beispiele für weitere Zusatzstoffe sind Kieselsäuren, deren Brechungsindex dem des fotopolymerisierbaren Gemisches angepaßt ist, insbesondere hydrophobierte Kieselsäuren mit großen Oberflächen ; Flußmittel wie, z. B. Calciumstearat, oder Trennmittel, wie z. B. Talkum in geringen Mengen. Die Elastizität und Härte beeinflußenden Zusatzstoffe werden im allgemeinen in Mengen von 5 bis 30 Gew.%, bezogen auf das gesamte fotopolymerisierbare Gemisch, eingesetzt. Weiterhin können zur Verbesserung der Belichtungseigenschaften den fotopolymerisierbaren Gemischen Vernetzungshilfsmittel zugesetzt werden, beispielsweise tri- oder tetrafunktionelle Mercapto-Verbindungen, wie sie unter anderem in der US-A 4 179 531 und US-A 4 234 676 für fotopolymerisierbare Gemische der in Rede stehenden Art beschrieben sind. Für die Verwendung als lichthärtende Klebstoffe können den erfindungsgemäßen fotopolymerisierbaren Gemischen auch klebrigmachende Harze, z. B. Kohlenwasserstoffharz, Kollophoniumester, Polyterpene, Cumaron-Inden-Harz etc., zugesetzt werden oder solche Verbindungen, wie sie beispielsweise in der US-A 4 133 731 beschrieben werden. Der Anteil der Zusatz- und/oder Hilfsstoffe an dem fotopolymerisierbaren Gemisch soll im allgemeinen insgesamt 40 Gew.% nicht übersteigen und liegt üblicherweise im Bereich von 5 bis 30 Gew.%, bezogen auf das gesamte fotopolymerisierbare Gemisch.

Die erfindungsgemäßen fotopolymerisierbaren Gemische können in an sich üblicher und bekannter Weise durch homogenes Vermischen der einzelnen Komponenten, beispielsweise in Lösung, einem Kneter oder Mischer hergestellt werden. Die erfindungsgemäßen Gemische zeichnen sich durch ihre gute Verarbeitbarkeit aus und sind insbesondere zur Herstellung von lichtempfindlichen Schichten beispielsweise für Überzüge, Klebstoffe, Haftlacke oder weichelastische Schichten geeignet. Schichten der gewünschten Schichtdicke aus den fotopolymerisierbaren Gemischen können beispielsweise durch Gießen aus Lösungen in einem geeigneten Lösungsmittel (wie Toluol, Xylol, Cyclohexan, Tetrahydrofuran, Methylisobutylketon oder Tetrachlorethylen) auf entsprechende Schichtträger hergestellt werden, was dadurch gut möglich ist, daß sich die elastomeren Blockcopolymerisate in den erfindungsgemäßen Gemischen durch niedrige Lösungsviskositäten auszeichnen und leicht eine Homogenisierung der Gemischbestandteile ermöglichen. Ebenso können derartige Schichten durch Pressen, Extrudieren und Kalandrieren hergestellt werden, wobei bei geeigneter Wahl der Inhibitoren keine thermische Anvernetzung zu befürchten ist. Die Schichtstärke ist in weiten Grenzen variabel und je nach Anwendungszweck leicht einstellbar.

Insbesondere eignen sich die erfindungsgemäßen fotopolymerisierbaren Gemische für lichtempfindliche Mehrschichtenelemente zur Herstellung von Reliefformen, beispielsweise Resiste und insbesondere weichelastischen Reliefdruckplatten für den Flexodruck. Solche fotopolymerisierbaren Aufzeichnungsmaterialien enthalten im allgemeinen eine fotopolymerisierbare Schicht aus der erfindungsgemäßen fotopolymerisierbaren Mischung auf einem dimensionsstabilen Schichtträger, wobei die Schichtdicke der fotopolymerisierbaren Schicht üblicherweise zwischen 0,01 und 6,5 mm liegt.

Als Schichtträger für die lichtempfindlichen mehrschichtigen Aufzeichnungsmaterialien eignen sich

5

flexible, dimensionsstabile Materialien mit ausreichend hohem Elastizitätsmodul. Hierzu gehören Metallplatten oder -folien, beispielsweise aus Stahlblech, Aluminiumblech, Kupfer oder dergleichen, sowie Folien aus Hochpolymeren, wie z. B. Folien aus Polyethylenterephthalat, Polybutylenterephthalat, Polyamid oder Polycarbonat. Die Auswahl der Schichtträger ist dabei nicht auf Platten oder Folien begrenzt, ebenso können Gewebe oder Vliese, wie Glasfasergewebe, als Trägermaterialien dienen. Neben der direkten Verankerung der fotopolymerisierbaren Schicht auf einen Schichtträger hoher Festigkeit und Dimensionsstabilität können zur Erzielung höherer Plattendicken, wie sie beim Flexodruck in der Praxis durch die Benutzung konventioneller Gummiklischees vorgegeben sind, als Unterschicht für die fotopolymerisierbare Schicht andere weichelastische Trägermaterialien eingesetzt werden, die ihrerseits mit einem dimensionsstabilen Schichtträger haftfest verbunden sind. Beispielsweise können für Mehrschichtverbundelemente weichelastische Unterschichten eingesetzt werden, wie sie in der DE-A 24 44 118 beschrieben sind.

In Abhängigkeit von den eingesetzten Materialien kann es bei den als fotopolymerisierbare Aufzeichnungsmaterialien verwendbaren Mehrschichtelementen zweckmäßig und notwendig sein, die fotopolymerisierbare Schicht auf dem Schichtträger mittels einer Haftschicht fest zu verankern. Diese Haftschicht kann als Zwischenlack in einer Schichtdicke von etwa 0,5 bis 40 μm verwendet werden. Als Haftschichten können handelsübliche Ein- oder Zwei-Komponentenkleber Anwendung finden, deren Art sich nach dem Schichtträgermaterial und nach den aufgebrachten Materialien der fotopolymerisierbaren Schicht richtet. Als häufig geeignete Kleber seien die handelsüblichen Reaktionskleber auf Polyurethan- und Polychloropren-Basis genannt, die durch Substrieren oder Gießen in geeigneter Schichtdicke auf die zu verbindenden Schichten aufgebracht werden können. Sehr gut geeignete Haftschichten bestehen aus einer Mischung von isocyanatgehärteten Phenoxyharzen und Polycarbonat gemäß DE-A 31 00 175 oder aus einem isocyanatgehärteten Celluloseetherhaftlack gemäß DE-A 31 07 741, wobei diese Haftschichten auch Lichthofschutzmittel enthalten können.

Es ist oft von Vorteil für die lichthärtbaren Mehrschichtenelemente, wenn auf der dem Schichtträger abgewandten Oberfläche der fotopolymerisierbaren Schicht noch eine haftfest verbundene, dünne, klebfreie Deckschicht aufgebracht ist. Eine solche Deckschicht besteht vorzugsweise aus einem klebfreie, transparente und reißfeste Filme bildenden Polymeren, welches in dem Entwicklerlösungsmittel für die fotopolymerisierbare Schicht löslich ist, z. B. einem Polyamid, Copolyamid, Polyurethan, Polyvinylalkohol, Polyvinylpyrrolidon, Polyethylenoxid mit Molekulargewichten über 100 000 oder Cyclokautschuk mit hohem Cyclisierungsgrad. Die Stärke dieser mit der fotopolymerisierbaren Schicht haftfest verbundenen Deckschicht beträgt zweckmäßigerweise etwa 0,5 bis 20 μm. Durch diese Deckschicht ist z. B. eine klebfreie, blasenfreie Negativauflage bei der Reliefdruckplattenherstellung möglich. Bei der Entwicklung der belichteten Anteile der fotopolymeren Schicht wird im allgemeinen diese Deckschicht mit den unvernetzten, unbelichteten Anteilen der fotopolymerisierbaren Schicht zusammen weggewaschen.

Es ist ferner oft von Vorteil, die als fotopolymerisierbare Aufzeichnungsmaterialien zu verwendenden lichtempfindlichen Mehrschichtenelemente mit einer abziehbaren Deckfolie zu versehen, wobei diese direkt auf der fotopolymerisierbaren Schicht aufgebracht sein kann oder zusammen mit der oben erwähnten haftfest verbundenen Deckschicht verwendet werden kann. Eine solche Deck- oder Schutzfolie, die beispielsweise aus Polyamid oder einem Polyester bestehen kann und die vorteilhafterweise eine Schichtstärke im Bereich von etwa 20 bis 150 μm besitzt, wird im allgemeinen vor der bildmäßigen Belichtung der lichtempfindlichen Mehrschichtmaterialien abgezogen ; bei hinreichender Transparenz der Deckschicht kann die Belichtung jedoch auch durch diese hindurch erfolgen, wobei die Deckschicht dann vor der Entwicklung abgezogen wird.

Für die Herstellung von elastomeren Reliefdruckformen besonders geeignete lichtempfindliche Mehrschichtenelemente enthalten zusätzlich zu den vorerwähnten Schichten noch eine weichelastische Unterschicht, wie sie in der DE-OS 24 44 118 beschrieben ist.

Die Herstellung der lichtempfindlichen Mehrschichtenelemente kann in an sich bekannter Weise erfolgen, indem man das homogene fotopolymerisierbare Gemisch zu einer Schicht der gewünschten Schichtdicke formt und mit dem dimensionsstabilen Schichtträger verbindet. Die fotopolymerisierbaren Schichten können dabei beispielsweise, wie erwähnt, aus Lösungen der Gemische durch Gießen auf die Schichtträger erzeugt werden oder durch Pressen, Kalandrieren oder Extrudieren der fotopolymerisierbaren Gemische hergestellt werden. Zur Herstellung der lichtempfindlichen Aufzeichnungsmaterialien können entweder vorgefertigte fotopolymerisierbare Schichten auf den gegebenenfalls mit einem Haftlack substrierten Schichtträger auflaminiert oder aufgepreßt werden, oder es kann das fotopolymerisierbare Gemisch als solches in geeigneter Weise, beispielsweise durch Gießen aus Lösung, auf den Schichtträger aufgebracht und hier zu der fotopolymerisierbaren Schicht geformt werden. Wegen der niedrigen Schmelzviskosität der erfindungsgemäß zu verwendenden elastomeren Blockcopolymerisate sind die fotopolymerisierbaren Gemische sehr vorteilhaft durch Extrudieren, Kalandrieren oder Pressen zu verarbeiten. Die erfindungsgemäßen fotopolymerisierbaren Gemische zeigen zudem eine gute Dosierbarkeit in Krümelform, was für die Beschickung von Extruder von großem Vorteil ist und eine Mitverwendung von Trennmitteln nicht erforderlich macht.

In an sich bekannter Weise können Schichten der erfindungsgemäßen Gemische durch Belichten in vernetzte, unlösliche Formteile, wie z. B. Dekorationsplatten oder Überzügen auf Folien oder Walzen

6

verarbeitet werden. Insbesondere eignen sich die lichtempfindlichen Mehrschichtenelemente mit einer fotopolymerisierbaren Schicht auf Basis der erfindungsgemäßen fotopolymerisierbaren Gemische zur Herstellung von Druck- und Reliefformen, was in an sich bekannter Weise durch bildmäßiges Belichten der fotopolymerisierbaren Schicht mittels aktinischem Licht und anschließendem Entfernen, insbesondere durch Auswaschen der unbelichteten bzw. unvernetzten Schichtanteile mit einem Entwicklerlösungsmittel zu einer Reliefform erfolgen kann. Für die Belichtung eignen sich die üblichen Lichtquellen von aktinischem Licht, wie beispielsweise handelsübliche UV-Fluoreszenzröhren, Quecksilbermittel-, -hoch- oder -niederdruckstrahler, sowie superaktinische Leuchtstoffröhren, Xenon-Impulslampen, Metalliodiddotierte Lampen, Kohlenbogenlampen etc. Die Strahlungsquellen sollen ein Licht einer Wellenlänge zwischen 230 und 450 nm aussenden, wobei die emittierte Wellenlänge bevorzugt bei 300 bis 420 nm liegt und auf die Eigenabsorption des in der fotopolymerisierbaren Schicht enthaltenen Fotoinitiators abgestimmt ist. Als Entwicklerlösungsmittel für das Auswaschen der unbelichteten, unvernetzten Schichtanteile nach der bildmäßigen Belichtung kommen aromatische Kohlenwasserstoffe oder halogenierte aliphatische Kohlenwasserstoff-Lösungsmittel in Betracht, wie beispielsweise 1,1,1-Trichlorethan, symmetrisches Tetrachlorethan, Tetrachlorethylen, Toluol, Methylisobutylketon oder Mischungen solcher Lösungsmittel mit niederen Alkoholen zur Steuerung der Auswaschwirkung. Nach dem Auswaschen mit dem Entwicklungslösungsmittel werden die resultierenden Reliefformen in üblicher Weise, gegebenenfalls bei Temperaturen bis zu 120 °C getrocknet. In manchen Fällen ist es zweckmäßig, die erhaltenen Reliefformen anschließend nochmals mit aktinischem Licht vollflächig nachzubelichten, um die Festigkeit der Formen bzw. Druckplatten zu erhöhen.

Besonders vorteilhaft lassen sich mit den erfindungsgemäßen lichtempfindlichen Mehrschichtenelementen weichelastische Druckformen herstellen, die für Anwendungsbereiche geeignet sind, bei denen eine elastische, nachgiebig druckende Fläche erforderlich ist. In diesen Fällen soll daher die fotopolymere, reliefbildende Schicht nach der Belichtung eine Shore-A-Härte (DIN 53505) von 30 bis 90, vorzugsweise von 40 bis 70, besitzen. Von großem Vorteil ist dabei die außerordentliche Klarheit der fotopolymerisierbaren Schichten aus den erfindungsgemäßen fotopolymerisierbaren Gemischen, wodurch Reliefdruckformen von sehr großer Relieftiefe mit geradem Flankenaufbau herstellbar sind, was für den Bereich des Bedruckens rauher und welliger Oberflächen, wie Wellpappe, Kartonagen und Servietten, erforderlich ist. Reliefhöhen von über 3 mm sind ohne Probleme wie bei konventionell geprägten Gummiklischees herstellbar, ohne daß es in der Tiefe der Reliefteile zum Zupolymerisieren kommt. Darüber hinaus ist es günstig, daß die elastomeren Blockcopolymerisate der erfindungsgemäßen fotopolymerisierbaren Gemische eine ausgezeichnete Anpassung der Polymerstruktur an die gewünschten mechanischen Eigenschaften in der fotovernetzten Schicht zulassen. Die aus den erfindungsgemäßen fotopolymerisierbaren Gemischen und lichtempfindlichen Mehrschichtenelementen hergestellten Druckformen zeigen ein ausgezeichnetes Druckverhalten, hohe Beständigkeit gegen Druckfarbenlösungsmittel und eine hohe Wiederverwendbarkeit der Druckformen insbesondere aufgrund der äußerst geringen Neigung zur Rißbildung bei Lagerung der hergestellten Druckformen.

Die vorliegende Erfindung wird durch die nachfolgenden Beispiele näher erläutert. Die in den Beispielen genannten Teile und Prozente beziehen sich, soweit nicht anders angegeben, auf das Gewicht. Volumenteile verhalten sich zu Teilen wie Liter zu Kilogramm. Die angegebenen Viskositätszahlen (ml/g) werden in Anlehnung an DIN 51562 und DIN 53726 bei 25 °C mit 0,5 gew.%iger Lösung der Polymeren in Toluol bestimmt. Die angegebenen Molekulargewichte $M_v$ sind aus der Viskositätszahl ermittelte Gewichtsmittel. Die Shore-A-Härte wurde ermittelt nach DIN 53505. Die Glasübergangstemperatur wird bestimmt nach DIN 53520. Die Stoßprallelastizität wird gemessen nach DIN 53512. Die Reißdehnung wird bestimmt nach DIN 53504.

Beispiel 1

Eine fotopolymerisierbare Mischung wurde hergestellt aus :

88 Teilen des nachfolgend beschriebenen Blockcopolymerisats,
7,3 Teilen Hexandioldiacrylat,
3,7 Teilen Hexandioldimethacrylat,
1,2 Teilen Benzildimethylketal,
0,008 Teilen eines schwarzen Farbstoffs (C.I. 26150, Solvent Black 3),
0,3 Teilen 2,6-Di-tert.-butyl-p-kresol.

Das Blockcopolymerisat war ein Dreiblock-Copolymerisat, bei dessen beiden endständigen Polymer-Blöcken es sich um statistisch aufgebaute Copolymerisat-Blöcke aus 10 Teilen Styrol und 5 Teilen Butadien mit einer Viskositätszahl von 20,2 ml/g und einer Glasübergangstemperatur von + 12 °C handelte und dessen mittelständiger Block ein Polyisopren-Block (Glasübergangstemperatur − 49 °C) darstellte, der 50 % des Blockcopolymerisats ausmachte. Das Gesamtmolekulargewicht des Blockcopolymerisats betrug 100 000, das Produkt hatte eine Viskositätszahl von 101 ml/g, eine Shore-A-Härte von 29 und eine Rückprallelastizität von 28. Eine 20 %ige Lösung des Blockcopolymerisats in Toluol hatte eine Transmission von 95 %, gemessen in 1 cm Schichtdicke gegen Toluol bei 360 nm.

Die Bestandteile der fotopolymerisierbaren Mischung wurden in 100 Teilen Toluol bei 90 °C gelöst. Die Lösung wurde auf eine mit einem handelsüblichen Copolyamid beschichtete Polyethylenterephthalatfolie aufgerakelt, so daß nach der Trocknung der Schicht bei 80 °C (Trocknungsdauer 1 Stunde) ein Film von 0,7 mm Dicke zurückblieb. Proben des so erhaltenen Mehrschichtenmaterials wurden in einem handelsüblichen Flachbelichter (40 Watt, UV-Fluoreszenzlampen) jeweils 30 Minuten belichtet. Die vernetzte Fotopolymerschicht der belichteten Proben hatte danach eine Shore-A-Härte von 49, eine Rückprallelastizität von 46 %, eine Reißfestigkeit von 6,8 N/mm² bei einer Reißdehnung von 273 %. Bei 100 % Dehnung wurde ein Zugmodul von 2,0 N/mm² gemessen.

Zur Herstellung einer Flexodruckform wurde eine mit Haftlack beschichtete 75 μm dicke Polyesterfolie auf die freie Oberfläche der oben hergestellten unbelichteten fotopolymerisierbaren Schicht aufgewalzt. Als Haftlack diente eine Mischung aus einem Isocyanat gehärteten Phenoxyharz und Polycarbonat, wie sie in der deutschen Patentanmeldung P 31 00 175 0 beschrieben ist. Nach Entfernen der Copolyamid beschichteten Polyesterdeckfolie verblieb die Copolyamidschicht auf der Oberfläche der fotopolymerisierbaren Schicht. Ein fotografisches Negativ wurde auf die fotopolymerisierbare Schicht gelegt, mit Hilfe eines Vakuumrahmens mit Folie auf die Schicht gepreßt und mit einem handelsüblichen Flachbelichter (40 Watt, UV-Fluoreszenzröhren) 12 Minuten belichtet. Dabei bleichte der in der fotopolymerisierbaren Schicht enthaltene Farbstoff bildmäßig aus, was zur Beurteilung der Belichtung diente. In einem handelsüblichen Sprühwascher wurde die belichtete, vernetzte Schicht 4,5 Minuten bei Raumtemperatur mit einem Lösungsmittelgemisch aus 9 Volumenteilen Tetrachlorethylen und 1 Volumenteil n-Butanol entwickelt, anschließend 1 Stunde bei 80 °C in einem Umlufttrockenschrank getrocknet und danach 30 Sekunden mit einer 0,4 %igen wäßrigen Bromlösung nachbehandelt. Nach 10 minütigem vollflächigem Nachbelichten wurde die erhaltene Druckform auf einen Druckzylinder aufgespannt, der seinerseits mit einem 1 mm dicken Überzug aus Naturgummi einer Shore-A-Härte von 30 beschichtet war. Die klebfreie Oberfläche der Reliefdruckform nahm die üblichen Flexodruckfarben ausgezeichnet an. Die erhaltenen Drucke zeigten eine exakte Wiedergabe der Vorlage mit randscharfen Details. Die Abriebsfestigkeit, Quellung und Elastizität der Druckform entsprach herkömmlichen Gummiklischees. Die Platte zeigte nach 200 000 Drucken keine Beschädigungen.

Beispiel 2

Es wurde ein Mehrschichtenelement gemäß Beispiel 1 hergestellt, auf dessen fotopolymerisierbare Schicht ein Testnegativ aufbelichtet wurde, das verschiedene Tonwerte von 10 %, 50 % und 90 % mit einer Rasterweite von 48 L/cm enthielt. Verwendet wurde ein handelsüblicher Flachbelichter mit 40 Watt-UV-Fluoreszenröhren ; die Belichtungszeit betrug 10 Minuten. Anschließend wurden die Proben in einem Tetrachlorethylen/n-Butanol-Gemisch (9 : 1-Volumenteilen) 5 Minuten bei Raumtemperatur ausgewaschen. Es wurden 4 verschiedene Proben hergestellt, die unterschiedlich nachbehandelt wurden :

Proben 1 und 2 : keine zusätzliche Behandlung
Proben 3 und 4 : zusätzlich 5 Minuten nachbehandelt mit 0,4 %iger wäßriger Bromlösung und 10 minütigem Nachbelichten ohne Abdecken.

Proben 2 und 4 wurden auf einen Blechzylinder von 5,8 cm Außendurchmesser aufgeklebt und bei Raumtemperatur offen gelagert. Proben 1 und 3 blieben flach gelagert. Alle 4 Proben wurden täglich auf Bildung von Rissen in der Oberfläche der Reliefschicht geprüft. Die Proben 1 bis 4 blieben länger als 30 Tage ohne Risse (Betrachtung bei 10facher Vergrößerung).

Vergleichsversuch A

Es wurde eine fotopolymerisierbare Mischung gemäß Beispiel 1 hergestellt, die jedoch anstelle des dort verwendeten elastomeren Blockcopolymerisats ein handelsübliches Polystyrol-Polyisopren-Polystyrol-Dreiblock-Copolymerisat enthielt. Das Blockcopolymer enthielt 84 % Isopren und hatte ein Gesamtmolekulargewicht von 130 000. In gleicher Weise wie in Beispiel 1 wurde durch Lösen und Vergießen eine 0,7 mm dicke fotopolymerisierbare Schicht hergestellt, von der wie in Beispiel 2 Versuchsproben gefertigt wurden, die unter den gleichen Bedingungen wie in Beispiel 2 hergestellt und gelagert wurden. Die unter Spannung gelagerten Proben 2 und 4 auf Blechzylindern zeigten bereits nach 4 Tagen mit bloßem Auge erkennbare Risse in der Oberfläche der Reliefteile, die die Schicht als Druckform unbrauchbar machten. Die Probe 3 (Flachlagerung mit Nachbehandlung) zeigte nach 24 bis 28 Tagen Risse ; die Probe 1 (Flachlagerung ohne weitere Nachbehandlung) hatte nach 5 bis 8 Tagen Risse.

Vergleichsversuch B

Analog zu Beispiel 1 wurde eine fotopolymerisierbare Mischung hergestellt, jedoch diesmal anstelle des elastomeren Blockcopolymerisats ein Dreiblock-Copolymerisat gemäß DE-A 29 42 183 eingesetzt, das aus 8 Teilen eines Polystyrolblocks, 76 Teilen eines Polyisoprenblocks und 16 Teilen eines statistischen Copolymerisatblocks aus Styrol und Butadien (2 : 1) bestand. Das Gesamtmolekulargewicht dieses Dreiblock-Copolymerisats betrug 130 000.

Zur Herstellung der fotopolymerisierbaren Schicht wurde wie in Beispiel 1 verfahren. Die fotopolymerisierbare Schicht wurde wie in Beispiel 2 beschrieben auf Bildung von Rissen geprüft, wobei nach 1- bis 2wöchiger Lagerung deutliche Rißbildung zu erkennen war.

## Beispiel 3

Eine fotopolymerisierbare Mischung wurde hergestellt aus :

85      Teilen des nachfolgend beschriebenen Blockcopolymerisats,
8      Teilen Hexandioldiacrylat,
4      Teilen Hexandioldimethacrylat,
1,2    Teilen Benzildimethylketal,
0,008 Teilen eines schwarzen Farbstoffes (C.I. 26150, Solvent Black 3),
0,4    Teilen 2,6-Di-tert.-butyl-p-kresol.

Die beiden außenliegenden Polymerblöcke des eingesetzten Dreiblock-Copolymerisats waren statistisch aufgebaute Styrol/Butadien-Copolymerisatblöcke (Styrol zu Butadien wie 2 : 1), der innenliegende Polymerblock war ein Polyisoprenblock und machte 70 % des Blockcopolymerisats aus. Das Gesamtmolekulargewicht des Blockcopolymerisats lag bei 165 000, die Viskositätszahl betrug 147,4 ml/g. Das Blockcopolymerisat hatte im unvernetzten Zustand eine Shore-A-Härte von 36, eine Rückprallelastizität von 26 %.

Eine aus der fotopolymerisierbaren Mischung hergestellte fotopolymerisierbare Schicht hatte nach der Belichtung und Fotovernetzung eine Shore-A-Härte von 50 und eine Rückprallelastizität von 34 %.

Zur Herstellung von Druckformen wurde aus der fotopolymerisierbaren Mischung durch Extrusion eine fotopolymerisierbare Schicht erzeugt, die mit einer Polyesterträgerfolie verbunden wurde. Als Deckschicht diente eine mit einem löslichen Copolyamid beschichtete Polyesterfolie, wobei die Copolyamidschicht nach Abziehen der Deckschicht auf der fotopolymerisierbaren Schicht zurückblieb. Die Herstellung und Prüfung von Druckformen erfolgten wie in Beispiel 2 beschrieben. Nach 30tägiger Lagerung der Druckformen konnte keine Rißbildung festgestellt werden.

## Vergleichsversuch C

Aus den in den Vergleichsversuchen A und B verwendeten fotopolymerisierbaren Gemischen wurden diesmal durch Extrusion fotopolymerisierbare Schichten hergestellt, die in gleicher Weise, wie in Beispiel 3 beschrieben, zur Herstellung von Reliefdruckformen eingesetzt und auf Rißbildung geprüft wurden. In allen Fällen war bereits nach wenigen Tagen deutliche Rißbildung erkennbar.

## Ansprüche

1. Fotopolymerisierbares Gemisch, enthaltend

(a) 40 bis 99 Gew.%, bezogen auf (a) und (b), mindestens eines in einem Entwicklerlösungsmittel löslichen elastomeren Blockcopolymerisats mit mindestens drei chemisch miteinander verknüpften Polymerblöcken,

(b) 1 bis 60 Gew.%, bezogen auf (a) und (b), mindestens einer mit dem elastomeren Blockcopolymerisat (a) verträglichen, fotopolymerisierbaren, ethylenisch ungesättigten niedermolekularen Verbindung,

(c) 0,1 bis 10 Gew.%, bezogen auf das fotopolymerisierbare Gemisch, mindestens eines Fotopolymerisationsinitiators sowie

(d) 0 bis 40 Gew.%, bezogen auf das fotopolymerisierbare Gemisch, an weiteren Zusatzstoffen,

dadurch gekennzeichnet, daß das Blockcopolymerisat (a) nur aus elastomeren Polymerblöcken aufgebaut ist, wobei das Blockcopolymerisat wenigstens zwei elastomere Polymerblöcke mit einer Glasübergangstemperatur zwischen − 20 °C und + 15 °C aufweist, die durch mindestens einen elastomeren Polymerblock mit einer Glasübergangstemperatur unter − 20 °C miteinander verknüpft sind.

2. Fotopolymerisierbares Gemisch gemäß Anspruch 1, dadurch gekennzeichnet, daß das elastomere Blockcopolymerisat (a) ein Molekulargewicht zwischen 60 000 und 300 000 besitzt.

3. Fotopolymerisierbares Gemisch gemäß Anspruch 2, dadurch gekennzeichnet, daß die Polymerblöcke des Blockcopolymerisats (a) mit einer Glasübergangstemperatur zwischen − 20 °C und + 15 °C ein Molekulargewicht zwischen 5 000 und 100 000 besitzen und der oder die Polymerblöcke mit einer Glasübergangstemperatur unter − 20 °C ein Molekulargewicht im Bereich von 20 000 bis 200 000 aufweisen.

4. Fotopolymerisierbares Gemisch gemäß Ansprüchen 1 bis 3, dadurch gekennzeichnet, daß der

oder die Polymerblöcke mit einer Glasübergangstemperatur unter − 20 °C 10 bis 90 Gew.% des elastomeren Blockcopolymerisats (a) ausmachen.

5. Fotopolymerisierbares Gemisch gemäß Ansprüchen 1 bis 4, dadurch gekennzeichnet, daß die Polymerblöcke mit einer Glasübergangstemperatur zwischen − 20 °C und + 15 °C endständig sind.

6. Fotopolymerisierbares Gemisch gemäß Anspruch 5, dadurch gekennzeichnet, daß das Blockcopolymerisat (a) ein Dreiblockcopolymerisat ist, dessen beiden endständigen Polymerblöcke durch einen mittelständigen Polymerblock mit einer Glasübergangstemperatur unter − 20 °C verknüpft sind.

7. Fotopolymerisierbares Gemisch gemäß Ansprüchen 1 bis 6, dadurch gekennzeichnet, daß der Polymerblock mit einer Glasübergangstemperatur unter − 20 °C ein Polybutadien- oder Polyisopren-Block ist.

8. Fotopolymerisierbares Gemisch gemäß Ansprüchen 1 bis 7, dadurch gekennzeichnet, daß die Polymerblöcke mit einer Glasübergangstemperatur zwischen − 20 °C und + 15 °C statistisch aufgebaute Copolymerisatblöcke aus Styrol, Butadien und/oder Isopren darstellen.

9. Als lichtempfindliches Aufzeichnungsmaterial, insbesondere für die Herstellung von Relief- und Druckformen, geeignetes Mehrschichtenelement mit einer auf einem dimensionsstabilen Schichtträger haftfest aufgebrachten fotopolymerisierbaren Schicht, dadurch gekennzeichnet, daß die fotopolymerisierbare Schicht aus einem fotopolymerisierbaren Gemisch gemäß Ansprüchen 1 bis 8 besteht.

**Claims**

1. A photopolymerizable mixture which contains

(a) from 40 to 99 % by weight, based on (a) and (b), of at least one elastomeric block copolymer which is soluble in a developer solvent and has at least three chemically linked polymer blocks,
(b) from 1 to 60 % by weight, based on (a) and (b), of at least one photopolymerizable ethylenically unsaturated low molecular weight compound compatible with the elastomeric block copolymer (a),
(c) from 0.1 to 10 % by weight, based on the photopolymerizable mixture, of at least one photopolymerization initiator, and
(d) from 0 to 40 % by weight, based on the photopolymerizable mixture, of further additives,

wherein the block copolymer (a) consists only of elastomeric polymer blocks, the block copolymer having at least two elastomeric polymer blocks which have a glass transition temperature of from − 20 °C to + 15 °C and are linked together by at least one elastomeric polymer block having a glass transition temperature below − 20 °C.

2. A photopolymerizable mixture as claimed in claim 1, wherein the elastomeric block copolymer (a) has a molecular weight of from 60,000 to 300,000.

3. A photopolymerizable mixture as claimed in claim 2, wherein the polymer blocks of the block copolymer (a), which have a glass transition temperature of from − 20 °C to + 15 °C, have a molecular weight of from 5,000 to 100,000, and the polymer block(s) having a glass transition temperature below − 20 °C has/have a molecular weight of from 20,000 to 200,000.

4. A photopolymerizable mixture as claimed in claims 1 to 3, wherein the polymer block(s) having a glass transition temperature below − 20 °C accounts/account for from 10 to 90 % by weight of the elastomeric block copolymer (a).

5. A photopolymerizable mixture as claimed in claims 1 to 4, wherein the polymer blocks having a glass transition temperature of from − 20 °C to + 25 °C are terminal blocks.

6. A photopolymerizable mixture as claimed in claim 5, wherein the block copolymer (a) is a three-block copolymer whose two terminal polymer blocks are linked by a central polymer block having a glass transition temperature below − 20 °C.

7. A photopolymerizable mixture as claimed in claims 1 to 6, wherein the polymer block having a glass transition temperature below − 20 °C is a polybutadiene or polyisoprene block.

8. A photopolymerizable mixture as claimed in claims 1 to 7, wherein the polymer blocks having a glass transition temperature of from − 20 °C to + 15 °C are random copolymer blocks of styrene, butadiene and/or isoprene.

9. A multilayer element useful as a photosensitive recording material, especially for the production of relief plates and printing plates, which comprises a dimensionally stable base and, applied thereto, a firmly adhering photopolymerizable layer, wherein the photopolymerizable layer consists of a photopolymerizable mixture as claimed in claims 1 to 8.

**Revendications**

1. Mélange photopolymérisable, contenant

(a) 40 à 99 % en poids, par rapport à (a) et (b) d'au moins un copolymérisat en bloc élastomère, soluble dans un solvant révélateur et ayant au moins trois blocs de polymères reliés entre eux chimiquement,

(b) 1 à 60 % en poids, par rapport à (a) et (b), d'au moins un composé de bas poids moléculaire, insaturé éthyléniquement, photopolymérisable et compatible avec le copolymérisat en blocs (a) élastomère,

(c) 0,1 à 10 % en poids, par rapport au mélange photopolymérisable, d'au moins un initiateur de photopolymérisation ainsi que

(d) 0 à 40 % en poids, rapportés au mélange photopolymérisable, d'autres additifs,

caractérisé par le fait que le copolymérisat en blocs (a) n'est constitué que de blocs de polymères élastomères, le copolymérisat en blocs comportant au moins deux blocs de polymère élastomères d'une température de transition vitreuse comprise entre − 20 °C et + 15 °C, et qui sont reliés par au moins un bloc de polymère-élastomère d'une température de transition vitreuse inférieure à − 20 °C.

2. Mélange photopolymérisable selon la revendication 1, caractérisé par le fait que le cópolymérisat en blocs (a) élastomère possède un poids moléculaire compris entre 60 000 et 300 000.

3. Mélange photopolymérisable selon la revendication 2, caractérisé par le fait que les blocs de polymère du copolymérisat en blocs (a) avec une température de transition vitreuse comprise entre − 20 °C et + 15 °C, possèdent un poids moléculaire compris entre 5 000 et 100 000 et le ou les blocs de polymère présentent, avec une température de transition vitreuse inférieure à − 20 °C, un poids moléculaire compris entre 20 000 et 200 000.

4. Mélange photopolymérisable selon les revendications 1 à 3, caractérisé par le fait que le ou les blocs de polymère d'une température de transition vitreuse inférieure à − 20 °C représentent 10 à 90 % en poids du copolymérisat en blocs (a) élastomère.

5. Mélange photopolymérisable selon les revendications 1 à 4, caractérisé par le fait que les blocs de polymère d'une température de transition vitreuse comprise entre − 20 °C et + 15 °C sont situés en bout de chaîne.

6. Mélange photopolymérisable selon la revendication 5, caractérisé par le fait que le copolymérisat en·blocs (a) est un copolymérisat à trois blocs, dont les deux blocs de polymère d'extrémité sont reliés par un bloc de polymère médian d'une température de transition vitreuse inférieure à − 20 °C.

7. Mélange photopolymérisable selon les revendications 1 à 6, caractérisé par le fait que le bloc de polymère d'une température de transition vitreuse inférieure à − 20 °C est un bloc de polybutadiène ou de polyisoprène.

8. Mélange photopolymérisable selon les revendications 1 à 7, caractérisé par le fait que les blocs de polymère d'une température de transition vitreuse comprise entre − 20 °C et + 15 °C, représentent des blocs de copolymérisat, statistiquement organisés de styrène, butadiène et/ou isoprène.

9. Elément multicouche, à couche photopolymérisable appliquée sur une couche-support stable en dimensions, approprié comme matériau d'enregistrement photosensible, en particulier pour la fabrication de formes en relief et d'impression, caractérisé par le fait que la couche photopolymérisable est constituée par un mélange photopolymérisable selon les revendications 1 à 8.